# EUROPÄISCHE PATENTANMELDUNG

(11) **EP 2 492 967 A2**
(43) Veröffentlichungstag der Anmeldung: **29.08.2012**
(21) Anmeldenummer: 12156708.5
(22) Anmeldetag: 23.02.2012
(51) Int. Cl.: H01L 31/042, H02H 5/04

(54) **Photovoltaikanlage mit Absicherung zur Brandbekämpfung**

(30) Priorität: 25.02.2011 DE 202011003245 U
(71) Anmelder: Conergy AG, 20537 Hamburg (DE)
(72) Erfinder: Bartholomäus, Lars, 15230 Frankfurt/Oder (DE)
(74) Vertreter: Eisenführ, Speiser & Partner

(57) **Zusammenfassung**

Die Erfindung betrifft eine Photovoltaikanlage, umfassend ein erstes Photovoltaikmodul, ein zweites Photovoltaikmodul, eine elektrische Verbindung zwischen dem ersten und dem zweiten Photovoltaikmodul, und eine elektrische Schaltvorrichtung zur Trennung der elektrischen Verbindung. Erfindungsgemäß umfasst die elektrische Schaltvorrichtung eine Schmelzsicherung (42) und eine Heizvorrichtung (46), welche ausgebildet und so zu der Schmelzsicherung angeordnet ist, dass bei Beheizung der Heizvorrichtung die Schmelzsicherung ausgelöst und die elektrische Verbindung getrennt wird.

## Beschreibung

Die Erfindung betrifft eine Photovoltaikanlage, umfassend ein erstes Photovoltaikmodul, ein zweites Photovoltaikmodul, eine elektrische Verbindung zwischen dem ersten und dem zweiten Photovoltaikmodul, und eine elektrische Schaltvorrichtung zur Trennung der elektrischen Verbindung.

Ein weiterer Aspekt der Erfindung ist eine elektrische Schaltung zur Verbindung eines ersten und eines zweiten Photovoltaikmoduls, umfassend eine elektrische Verbindung zwischen dem ersten und dem zweiten Photovoltaikmodul, und eine elektrische Schaltvorrichtung zur Trennung der elektrischen Verbindung.

Photovoltaikanlagen der vorbezeichneten Art werden dazu eingesetzt, um einfallendes Licht in elektrischen Strom zu wandeln. Sie werden zu diesem Zweck in der Regel auf Hausdächern installiert. Die Installation erfolgt dabei solcherart, dass ein oder mehrere Photovoltaikmodule auf dem Hausdach installiert werden und über eine elektrische Leitung den darin erzeugten Strom zu den Verbrauchern innerhalb des Hauses und/oder in das öffentliche Netz einspeisen. Zum Zwecke der Einspeisung ist es hierbei erforderlich, den in den Photovoltaikmodulen erzeugte Strom mittels eines Wechselrichters in eine der Netzspannung entsprechende Wechselspannung zu wandeln. Der Wechselrichter ist hierbei typischerweise im Untergeschoss des Gebäudes angeordnet und mit den Photovoltaikmodulen über eine Leitung verbunden.

Eine spezifische Problematik, die im Zusammenhang mit solchen Photovoltaikmodulen auftritt, ist die Gefährdung der Rettungsmaßnahmen im Falle eines Hausbrandes. Regelmäßig stehen Personen, die einen Hausbrand an einem Haus bekämpfen, das mit Photovoltaikmodulen bestückt ist, vor der Gefährdung, bei Einsatz von Löschmitteln, wie beispielsweise Löschwasser, durch elektrische Spannungen, die über das Löschmittel von den Photovoltaikmodulen zu den löschenden Personen oder Einsatzfahrzeugen geleitet werden, gesundheitlich gefährdet zu werden.

Grundsätzlich ist es beispielsweise bekannt, Photovoltaikanlagen im Bereich des Wechselrichters solcherart zu schalten, dass die einzelnen Photovoltaikmodule kurzgeschlossen sind, um auf diese Weise das Auftreten hoher Spannungen im Falle der Brandbekämpfung zu vermeiden. Nachteilhaft an diesen Schaltungen ist jedoch, dass sie nicht zuverlässig schalten und insbesondere im Brandfall ausfallen können, so dass die Spannungsfreischaltung der Photovoltaikmodule nicht zuverlässig erfolgt.

Es besteht daher ein Bedarf für eine Photovoltaikanlage, die gegenüber dem Stand der Technik eine verbesserte Sicherheit gegen ein elektrisches Gefährdungspotenzial für Personen bietet, die einen Brand bekämpfen, der in oder im Bereich der Photovoltaikanlage auftritt.

Die Erfindung löst diese Problematik bei einer Photovoltaikanlage der eingangs genannten Art, indem die elektrische Schaltvorrichtung eine Schmelzsicherung und eine Heizvorrichtung umfasst, welche ausgebildet und so zu der Schmelzsicherung angeordnet ist, dass bei Beheizung der Heizvorrichtung die Schmelzsicherung auslöst und die elektrische Verbindung trennt. Mit der erfindungsgemäß bereitgestellten Photovoltaikanlage wird einerseits durch Anordnung einer Schmelzsicherung in einer elektrischen Verbindung zwischen zwei Photovoltaikmodulen im unmittelbaren Bereich der Photovoltaikmodule erreicht, dass im Falle eines Brandes im unmittelbaren Bereich der Photovoltaikmodule zuverlässig aufgrund der Hitzeeinwirkung diese elektrisch voneinander getrennt werden. Auf diese Weise wird der Aufbau hoher Spannung zuverlässig verhindert, da nur noch die Spannungen aus einzelnen Photovoltaikmodulen erzeugt werden kann, die in der Regel ausreichend niedrig ist, um eine Gefährdung von Brandbekämpfungspersonal zu vermeiden.

Darüber hinaus wird durch Bereitstellung der Heizvorrichtung im thermischen Kontakt zur Schmelzsicherung ermöglicht, die Schmelzsicherung aktiv zu einem Zeitpunkt auszulösen, zu dem eine Gefährdung befürchtet oder absehbar ist und vorsorglich zum Zwecke einer Gefahrverringerung die Photovoltaikmodule elektrisch voneinander getrennt werden sollen. Diese elektrische Trennung wird in einem solchen Fall erreicht, indem die Heizvorrichtung betrieben wird und hierdurch die zum Durchbrennen der Schmelzsicherung erforderliche Temperatur erreicht bzw. überschritten wird.

Ein dabei auftretender Vorteil der erfindungsgemäßen Lösung besteht darin, dass sowohl Schmelzsicherung als auch Heizvorrichtung unmittelbar benachbart zu den Photovoltaikmodulen angeordnet sind und demzufolge die Trennung der elektrischen Verbindung zwischen den Photovoltaikmodulen unmittelbar auf dem Dach bewirken können, ohne dass hierzu eine Abhängigkeit von einer elektrischen Leitung von den Photovoltaikmodulen zu einer Schaltungssicherheitseinrichtung notwendig wäre. Ein Versagen der elektrischen Trennung der beiden Photovoltaikmodule voneinander ist hierdurch weitestgehend ausgeschlossen und es wird folglich eine erhöhte Sicherheit gegenüber den Lösungen nach dem Stand der Technik erreicht.

Die Heizvorrichtung ist vorzugsweise eine elektrische Heizvorrichtung und kann mittels eines unabhängigen Schaltkreises mit Heizstrom beaufschlagt werden oder mittels eines elektrischen Heizstromkreises, der in die elektrischen Leitungen der Photovoltaikanlage integriert ist und insbesondere elektrische Leitungen der Photovoltalkanlage mitnutzt. So kann im einfachsten Fall die Heizvorrichtung als elektrische Widerstandsheizung ausgeführt. Die Heizvorrichtung ist dabei vorzugsweise thermisch an die Schmelzsicherung angekoppelt, das heißt in direktem Kontakt zur unmittelbaren Wärmeleitung aus der Heizvorrichtung in die Schmelzsicherung, z.B. indem die Heizvorrichtung die Schmelzsicherung allseitig umgibt, um diese herumgewickelt ist oder einseitig an dieser anliegt.

Gemäß einer ersten bevorzugten Ausführungsform einer erfindungsgemäßen Photovoltaikanlage, welche die Photovoltaikmodule über einen Anschluss mittels einem ersten und einem zweiten Leiter mit einem Wechselrichter verbindet, ist vorgesehen, dass die elektrische Schaltvorrichtung fortgebildet ist, indem die Heizvorrichtung über den gleichen Anschluss mit dem ersten und zweiten Leiter verbindbar sind zur Beaufschlagung der Heizvorrichtung mit einem Heizstrom.

Gemäß dieser bevorzugten Ausführungsform ist ein den Photovoltaikmodulen gemeinsamer Anschluss vorhanden, von dem aus eine elektrische Leitung zu einem Wechselrichter gelegt werden kann, um den Wechselrichter mit den Photovoltaikmodulen zu verbinden und folglich einen als Netzstrom nutzbaren Wechselstrom aus dem in den Photovoltaikmodulen erzeugten Gleichstrom zu erzeugen. Diese elektrische Leitung mit einem ersten und zweiten Leiter wird zugleich dazu verwendet, um die Heizvorrichtung mit einem Heizstrom zu versorgen, wenn die Heizvorrichtung betrieben werden soll, um die Schmelzsicherung durchbrennen zu lassen. Auf diese Weise ist es nicht erforderlich, zusätzliche Leitungen, insbesondere Signalleitungen oder Versorgungsleitungen, vorzusehen, um die Heizvorrichtung zu betreiben, anzusteuern und folglich die Auslösung der erfindungsgemäßen Brandschutzsicherung auszulösen. Zudem wird durch diese Lösung eine Nachrüstbarkeit erreicht, die eine einfache Nachrüstung der erfindungsgemäßen Brandschutzsicherung in bestehende, nicht für den Brandfall abgesicherte Photovoltaikanlagen möglich ist.

Noch weiter ist es gemäß einer weiteren Ausführungsform bevorzugt, dass die elektrische Schaltvorrichtung fortgebildet ist, indem sie einen ersten Anschlusspol zum Anschluss des ersten Photovoltaikmoduls und einen zweiten Anschlusspol zum Anschluss des zweiten Photovoltaikmoduls aufweist und dass der erste und der zweite Anschlusspol durch eine erste elektrische Verbindung, welche die Schmelzsicherung beinhaltet, und eine zweite, parallel zur ersten elektrischen Verbindung zwischen den ersten und zweiten Anschlusspol verlaufenden elektrischen Verbindung miteinander verbunden sind, wobei die Heizvorrichtung in der zweiten elektrischen Verbindung angeordnet ist.

Gemäß dieser Ausführungsform wird eine spezifische Schaltungsanordnung vorgeschlagen, die eine insoweit vorteilhafte und einfache Anordnung von Heizvorrichtung und Schmelzsicherung zueinander in zwei parallelen Leitungssträngen vorsieht. Dabei kann die Auslösung der Schmelzsicherung, erreicht durch eine Aktivierung der Heizvorrichtung, bewirkt werden, indem der Strom durch die Leitungen, welche die Photovoltaikmodule anschließen, verändert wird, beispielsweise indem ein von einer entsprechenden Schaltungseinheit im Bereich der Heizvorrichtung wahrnehmbarer Signalimpuls auf diese Leitungen aufgegeben wird, um eine Freischaltung der Heizvorrichtung zu bewirken, oder indem die Stromrichtung geändert wird, bei hierbei entsprechend vorgesehenen Stromrichtungssperren oder indem ein Wechsel- statt Gleichstrom auf den Leitungen liegt oder ein Wechselstrom auf den Gleichstrom aufgesetzt wird und durch eine entsprechende elektrische Filtereinheit in dem Leitungsstrang der Heizvorrichtung diese Wechselspannung zum Betrieb der Heizvorrichtung als Heizstrom durchgeleitet wird, der von den Photovoltaikmodulen erzeugte Gleichstrom jedoch nicht.

Dabei ist es hierbei gemäß einer ersten besonders bevorzugten Ausführungsform vorgesehen, dass die elektrische Schaltvorrichtung fortgebildet ist, indem in der zweiten elektrischen Verbindung ein Kondensator in Reihe zu der Heizvorrichtung angeordnet ist. Mit dieser Ausgestaltung wird ein Filterelement in Form des Kondensators in den Leitungsstrang eingebaut, in dem die Heizvorrichtung angeordnet ist. Hierdurch wird es ermöglicht, dass durch Anlegen einer Wechselspannung auf die Verbindungsleitungen der Photovoltaikmodule die Heizvorrichtung betrieben wird, da der Kondensator diese Wechselspannung durchlässt. Zugleich wird durch den Kondensator vermieden, dass die Heizvorrichtung durch den in den Photovoltaikmodulen im regulären Betrieb erzeugten Gleichstrom aufgeheizt wird, so dass die Aktivierung der Brandschutzsicherung in einer einfachen und zuverlässigen Weise durch Anlegen einer Wechselspannung an die Leitungen der Photovoltalkanlage erfolgen kann.

Dabei ist es gemäß einer besonders bevorzugten Ausführungsform weiter vorgesehen, dass eine Wechselstromquelle, die mit der Heizvorrichtung zur Beaufschlagung der Heizvorrichtung mit einem Wechselstrom elektrisch verbunden ist, vorgesehen ist. Eine solche Wechselstromquelle ermöglicht es, durch eine einfache Umschaltung und Aufschaltung des Wechselstroms aus dieser Wechselstromquelle die Auslösung der Schmelzsicherung zu erwirken.

Gemäß einer zweiten besonders bevorzugten Ausführungsform ist vorgesehen, dass die elektrische Schaltvorrichtung fortgebildet ist, indem in der ersten elektrischen Verbindung eine erste Diode in einer ersten Sperrrichtung von dem ersten zum zweiten Anschlusspol in Reihe zu der Schmelzsicherung angeordnet ist, und in der zweiten elektrischen Verbindung eine zweite Diode in einer zweiten, der ersten entgegengesetzten Sperrrichtung von dem zweiten zum ersten Anschlusspol in Reihe zu der Heizvorrichtung angeordnet ist.

Gemäß dieser Ausführungsform wird die Heizvorrichtung mit einem Gleichstrom betrieben, der jedoch in einer bestimmten Stromrichtung fließen muss, die entgegen der Stromrichtung der Photovoltaikmodule gerichtet ist. Durch Bereitstellung einer nur in einer Richtung durchlässigen Diode im Leitungsstrang der Heizvorrichtung kann hierbei eine einfache Schaltungsmöglichkeit mit einem sicheren Betrieb realisiert werden, indem der durch die Photovoltaikmodule erzeugte Strom aufgrund dieser in Reihe geschalteten Diode die Heizvorrichtung nicht durchfließen kann, wohingegen durch eine Beaufschlagung der elektrischen Verbindung mit einem hierzu entgegengesetzten elektrischen Strom die Heizvorrichtung von Strom durchflossen wird und sich folglich aufheizt und die Schmelzsicherung auslöst. Dabei kann insbesondere die Schmelzsicherung wiederum mit einer zu dieser Diode im Leitungsstrang der Heizvorrichtung angeordneten Diode entgegengesetzten Sperrrichtung in Reihe geschaltet sein, um zu verhindern, dass der Heizstrom auch über den Paralleistrang der Schmelzsicherung geleitet wird, wodurch die Auslösegeschwindigkeit aufgrund der alleinigen Durchleitung des Heizstroms über den Leitungsstrang der Heizvorrichtung eine schnellere Aufheizung erreicht wird.

Dabei ist es gemäß dieser bevorzugten Ausführungsform weiter vorgesehen, eine Gleichstromquelle, die mit der Heizvorrichtung zur Beaufschlagung der Heizvorrichtung mit einem Gleichstrom in Durchlassrichtung der zweiten Diode verbunden ist, bereitzustellen. Diese Gleichstromquelle dient dazu, um eine zuverlässige Auslösung der Schmelzsicherung durch Beaufschlagung der Heizvorrichtung mit dem Gleichstrom aus dieser Gleichstromquelle zu erreichen. Die Gleichstromquelle kann insbesondere beabstandet von den Photovoltaikmodulen angeordnet sein und über elektrische Leitungen, welche das Photovoltaikmodul mit einem Wechselrichter verbinden, seinen Gleichstrom zu der Heizvorrichtung leiten.

Weiterhin ist es bei einer erfindungsgemäßen Photovoltaikanlage mit einem Wechselrichter in einem Wechselrichtergehäuse, der beabstandet von dem ersten und zweiten Photovoltaikmodul angeordnet und mit diesem elektrisch über eine Leitung mit einem ersten und einem zweiten Leiter verbunden ist, bevorzugt, diese weiter fortzubilden durch eine Heizstromquelle, die mit der Heizvorrichtung mittels des ersten und zweiten Leiters elektrisch verbunden ist und die vorzugsweise in dem Wechselrichtergehäuse oder benachbart zu diesem angeordnet ist. Gemäß dieser Ausführungsform wird eine Heizstromquelle bereitgestellt, die insbesondere beabstandet von den Photovoltaikmodulen im Bereich des Wechselrichters angeordnet ist und hierdurch einen kompakten Aufbau, durch Nutzung der elektrischen Leitungen zwischen dem Wechselrichter und den Photovoltaikmodulen eine leichte Nachrüstbarkeit bzw. Installation und zugleich eine sichere Auslösung der Schmelzsicherung durch Betätigung einer Schaltvorrichtung im Keller des betroffenen Gebäudes ermöglicht.

Noch weiter ist es bevorzugt, dass die Schmelzsicherung zur irreversiblen Trennung der elektrischen Verbindung zwischen dem ersten und dem zweiten Photovoltaikmodul ausgebildet ist. Gemäß dieser Fortbildungsform wird eine versehentliche Kontaktwiederherstellung im Bereich der Schmelzsicherung zuverlässig vermieden, indem eine irreversible Trennung bei Auslösen der Schmelzsicherung erreicht wird. Diesem Fortbildungsgedanken liegt die Erkenntnis zugrunde, dass die häufig verwendeten Automatiksicherungen bei Brandeinwirkung oder Einwirkung mechanischer Kräfte, wie sie im Laufe eines Brandes und einer Bekämpfung eines Brandes auf solche Schaltungseinrichtungen einwirken können, unter ungünstigen Bedingungen dazu neigen, den elektrischen Kontakt zwischen zwei Photovoltaikmodulen wiederherzustellen, wodurch dann im Verlauf des Brandes wieder gefährlich hohe Spannungen auftreten können.

Gemäß einer weiteren bevorzugten Ausführungsform ist vorgesehen, dass die elektrische Schaltvorrichtung fortgebildet ist, indem die elektrische Verbindung einen ersten, mit dem ersten Photovoltaikmodul verbundenen ersten Anschlusspol über die Schmelzsicherung mit einem zweiten, mit dem zweiten Photovoltaikmodul verbundenen zweiten Anschlusspol verbindet und ausgebildet ist, um bei Überschreitung einer vorbestimmten Temperatur den ersten von dem zweiten Anschlusspol elektrisch voneinander zu trennen und den ersten oder den zweiten Anschlusspol mit einem Massepunkt zu verbinden. Gemäß dieser bevorzugten Ausführungsform wird nicht nur die elektrische Verbindung zwischen dem ersten und zweiten Photovoltaikmodul mittels der Schmelzsicherung getrennt, sondern hierbei zusätzlich eine Erdung von einem der beiden Photovoltaikmodule mittels des entsprechenden Anschlusspols zugleich erzielt. Durch diese Erdung des Photovoltaikmoduls wird eine zusätzliche Sicherheit bereitgestellt, da auftretende Spannungen folglich abgeleitet werden können und durch die Bereitstellung eines praktisch widerstandsfreien Masseschlusses die Gefahr einer Ableitung solcher Spannungen über Löschmittel zum Brandschutzbekämpfungspersonal weiter verringert werden kann.

Dabei ist es bei einer Photovoltaikanlage mit drei oder mehr miteinander elektrischen verbundenen Photovoltaikmodulen insbesondere gemäß einer weiteren bevorzugten Ausführungsform vorgesehen, dass jeweils eine elektrische Verbindung zwischen zwei Photovoltaikmodulen ausgebildet ist und jede elektrische Verbindung eine elektrische Schaltvorrichtung mit den Merkmalen der elektrischen Schaltvorrichtung nach einem der vorhergehenden Ansprüche aufweist, wobei jede elektrische Schaltvorrichtung fortgebildet ist, indem die elektrische Verbindung einen ersten, mit dem ersten Photovoltaikmodul verbundenen ersten Anschlusspol über die Schmelzsicherung mit einem zweiten, mit dem zweiten Photovoltaikmodul verbundenen zweiten Anschlusspol verbindet und ausgebildet ist, um bei Überschreitung einer vorbestimmten Temperatur den ersten von dem zweiten Anschlusspol elektrisch voneinander zu trennen und den ersten oder den zweiten Anschlusspol mit einem Massepunkt zu verbinden. Gemäß dieser bevorzugten Ausführungsform werden mehrere Photovoltaikmodule, die angeordnet sind und elektrisch miteinander jeweils von zwei benachbarten Photovoltaikmodulen verbunden sind, jeweils individuell voneinander getrennt und ein Pol jedes Photovoltaikmoduls durch jeweils eine zwischen den Photovoltaikmodulen angeordnete Schaltung geerdet. Dabei ist zu verstehen, dass die Mehrzahl der entsprechenden erfindungsgemäß bereitgestellten Schaltungseinrichtungen jeweils übereinstimmend ausgerichtete bzw. gepolte Pole der mehreren Photovoltaikmodule an Masse legen, so dass jedes der Photovoltaikmodule im Falle eines Brandes geerdet wird.

Ein weiterer Aspekt der Erfindung ist eine elektrische Schaltung der eingangs beschriebenen Art, welche sich dadurch auszeichnet, dass die elektrische Schaltvorrichtung eine Schmelzsicherung und eine Heizvorrichtung umfasst, welche ausgebildet und so zu der Schmelzsicherung angeordnet ist, dass bei Beheizung der Heizvorrichtung die Schmelzsicherung auslöst und die elektrische Verbindung trennt.

Die elektrische Schaltung weist die Eigenschaften und Vorteile der zuvor erläuterten elektrischen Schaltvorrichtung auf und eignet sich insbesondere dafür, um bestehende Photovoltaikanlagen nachzurüsten und hierdurch für den Brandfall zur Sicherung des Brandbekämpfungspersonals abschalten zu können.

Die elektrische Schaltung kann insbesondere nach den zuvor beschriebenen Merkmalen der elektrischen Schaltvorrichtung fortgebildet werden.

Die erfindungsgemäße Photovoltaikanlage wird bevorzugt nach einem Verfahren zur Sicherung einer Photovoltaikanlage betrieben, die mehrere, elektrisch miteinander verbundene Photovoltaikmodule aufweist, indem im Falle eines Brandes folgende Schritte durchgeführt werden: Beaufschlagen einer im Bereich der Photovoltaikmodule angeordneten Heizvorrichtung mit einem Heizstrom, Beheizen einer im Bereich der Heizvorrichtung angeordneten Schmelzsicherung mittels der Heizvorrichtung, Durchtrennen der Schmelzsicherung mittels der Temperatureinwirkung aus der Heizvorrichtung und hierdurch Trennen der elektrischen Verbindung zwischen dem ersten und zweiten Photovoltaikmodul.

Das Verfahren kann dabei fortgebildet werden, wenn der in den Photovoltaikmodulen erzeugte Strom über einen ersten und einen zweiten elektrischen Leiter zu einem beabstandet angeordneten Wechselrichter geleitet wird, indem ein Heizstrom über den ersten und zweiten Leiter zu der Heizvorrichtung geleitet wird, und der Heizstrom als Wechselstrom zu einer parallel zur Schmelzsicherung geschalteten Heizeinheit geleitet wird, welche die in Reihe zu einem Kondensator geschaltete Heizvorrichtung umfasst, oder der Heizstrom als Gleichstrom zu einer parallel zur Schmelzsicherung geschalteten Heizeinheit geleitet wird, welche die in Reihe zu einer Diode geschaltete Heizvorrichtung umfasst.

Bevorzugte Ausführungsformen der Erfindung werden anhand der beiliegenden Figuren erläutert. Es zeigen:
- Fig. 1: eine schematische Darstellung einer erfindungsgemäßen Photovoltaikanlage mit drei Photovoltaikmodulen,
- Fig. 2: eine schematische Darstellung einer ersten Schaltungseinrichtung zwischen zwei Photovoltaikmodulen, und
- Fig. 3: eine zweite bevorzugte Ausführungsform einer ersten Schaltungseinrichtung zwischen zwei Photovoltaikmodulen.

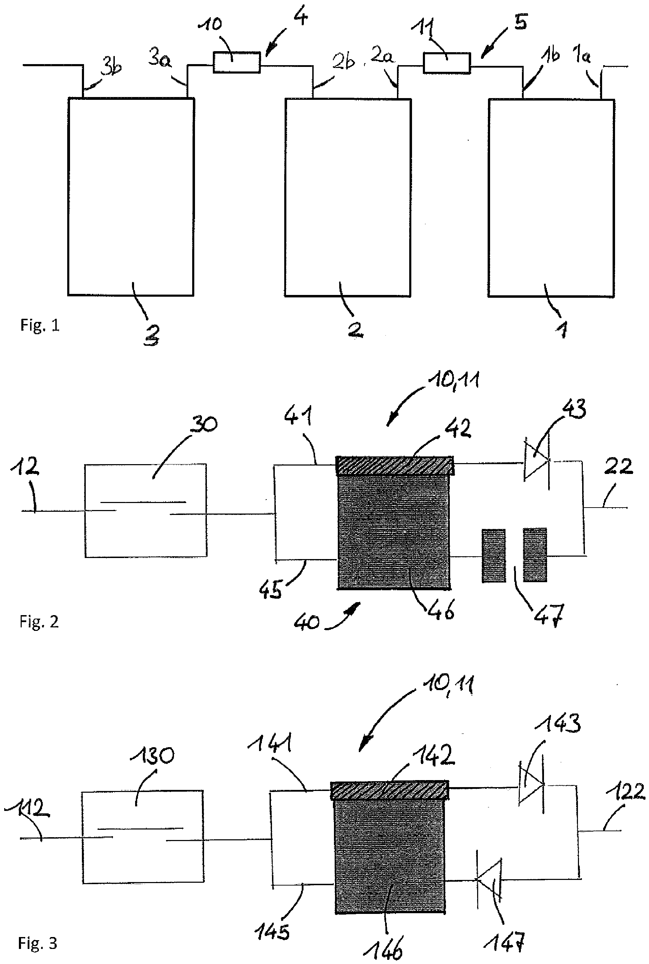

Bezugnehmend zunächst auf Fig. 1 ist eine Photovoltaikanlage gezeigt, die über mehrere Photovoltaikmodule 1, 2, 3 verfügt. Die Photovoltaikmodule 1, 2, 3 erzeugen bei einfallendem Licht einen Gleichstrom, der jeweils über einen Pluspol 1a, 2a, 3a und einen Minuspol 1b, 2b, 3b aus den Photovoltaikmodulen herausgeleitet wird.

Die Photovoltaikmodule 1-3 sind mittels elektrischer Verbindungen 4,5 in Reihe geschaltet, indem ein negativer Pol 1b eines Photovoltaikmoduls 1 mit einem Pluspol 2a eines benachbarten Photovoltaikmoduls 2 verbunden ist und der Minuspol 2b dieses Photovoltaikmoduls wiederum mit einem Pluspol 3a eines benachbarten Photovoltaikmoduls 3 usw. elektrisch verbunden ist. Die elektrische Verbindung wird mittels fest installierter Leitungen erzielt.

In jede elektrische Leitung ist eine elektrische Schaltvorrichtung 10, 11 eingesetzt.

In Fig. 2 ist eine solche elektrische Schaltvorrichtung 10, 11, in einer ersten Ausführungsform gezeigt. Die elektrische Schaltvorrichtung weist einen ersten Anschlusspol 12 für ein erstes Photovoltaikmodul und einen zweiten Anschlusspol 22 für ein zweites Photovoltaikmodul aufweist. Zwischen den ersten Anschlusspol 12 und den zweiten Anschlusspol 22 ist ein Bimetallschalter 30 in Reihe mit einer Parallelschaltungseinheit 40 elektrisch verbunden. Der Bimetallschalter 30 ist bei Normaltemperaturen geschlossen und so ausgelegt, dass er bei Überschreitung dieser Normaltemperaturen getrennt wird. Dies bewirkt eine erste Absicherung gegen Brandeinwirkungen, die unmittelbar auf die Schaltungsvorrichtung einwirken und kann eine Trennung der an die Anschlusspole 12, 22 angeschlossenen Photovoltaikmodule bei unmittelbarer Hitzeeinwirkung auf die Schaltungsvorrichtung erreichen.

Die Paralielschaltungseinheit 40 umfasst zwei parallele Leitungsstränge 41, 45. In dem Parallelleitungsstrang 41 sind eine Schmelzsicherung 42 und eine Diode 43 in Reihe angeordnet. Die Diode 43 ist in Durchlassrichtung vom ersten Anschlusspol zum zweiten Anschlusspol eingesetzt und sperrt folglich Strom, der vom zweiten Anschlusspol zum ersten Anschlusspol fließt.

Im zweiten Leitungsstrang 45 ist eine elektrische Widerstandsheizung 46 in Reihe mit einem Kondensator 47 angeordnet. Die elektrische Widerstandsheizung 46 steht in direktem Wärmeleitkontakt mit der Schmelzsicherung 42.

im Normalbetrieb wird die Schaltungsvorrichtung gemäß Fig. 2 so betrieben, dass der durch die Photovoltaikmodule erzeugte Strom von dem ersten Anschlusspol 12 zum zweiten Anschlusspol 22 fließt. Die Photovoltaikmodule werden hierdurch in Reihe geschaltet, was eine Aufaddierung der in ihnen erzeugten Spannungen bewirkt und folglich eine für die weitere Nutzung günstige Erzeugung eines Stroms mit hoher Spannung erzielt.

Der Kondensator 47 bewirkt in diesem Normalbetrieb eine Sperrung des Parallelleitungsstrangs 45, wodurch die elektrische Widerstandsheizung 46 sich durch den in den Photovoltaikmodulen erzeugten Strom nicht aufheizen kann.

Im Falle eines Brandes ist es erforderlich, diese hohe Spannung zu reduzieren oder im Idealfall vollständig zurückzufahren. Zu diesem Zweck muss die Verbindung zwischen den beiden Photovoltaikmodulen an den Anschlusspolen 12, 22 getrennt werden. Hierzu wird bei der Ausführungsform gemäß Fig. 2 eine Wechselspannung auf die Photovoltaikmodule aufgegeben, welche folglich auch über den ersten und zweiten Anschlusspol 12, 22 auf die Schaltungsvorrichtung 10, 11 einwirkt. Diese Wechselspannung wird von dem Kondensator 47 durchgelassen, so dass ein Wechselheizstrom auf die elektrische Widerstandsheizung 46 einwirkt und diese aufheizt. Die Aufheizung und dadurch erzeugte Temperatur wird unmittelbar auf die Schmelzsicherung thermisch übertragen, woraufhin diese durchbrennt und folglich den ersten Anschlusspol 12 vom zweiten Anschlusspol 22 insoweit zur Vermeidung der Durchleitung von Gleichstrom wirksam trennt.

Fig. 3 zeigt eine zweite Variante der erfindungsgemäßen Schaltungsvorrichtung. Wiederum ist ein erster Anschlusspol 112 und ein zweiter Anschlusspol 122 vorhanden, an dem ein erstes Photovoltaikmodul und ein zweites Photovoltaikmodul entsprechend angeschlossen und diese miteinander elektrisch in Reihe verbunden werden können.

Wiederum ist ebenfalls ein Bimetallschalter 130 in Reihe zu einer Parallelschalteinheit zwischen die beiden Anschlusspole elektrisch verbunden. Der Bimetallschalter 130 hat die gleiche Funktion wie der zuvor erläuterte Bimetallschalter 30.

In der Parallelschalteinheit ist ein erster Parallelleitungsstrang 141 und ein zweiter Parallelleitungsstrang 145 vorgesehen. Der erste Parallelleitungsstrang 141 umfasst hierbei eine Schmelzsicherung 142 und eine zu dieser in Reihe geschaltete Diode 142 und dient der Durchleitung eines in den Photovoltaikmodulen erzeugten Stromes von bis zu 20 A.

In dem hierzu parallel angeordneten zweiten Parallelleitungsstrang 145 ist eine elektrische Widerstandsheizung 146 und eine zweite Diode 147 angeordnet. Die zweite Diode 147 ist mit einer zu der ersten Diode entgegengesetzten Sperrrichtung in Reihe zu der Heizvorrichtung 146 eingesetzt. Sie verhindert somit, dass der von den Photovoltaikmodulen über den ersten Anschlusspol 110 und den zweiten Anschlusspol 120 fließende Strom die elektrische Widerstandsheizung 146 aufheizt. Dieser von den Photovoltaikmodulen erzeugte Strom fließt somit einzig über die Schmelzsicherung 141 und die Diode 142 vom ersten Photovoltaikmodul zum zweiten Photovoltaikmodul.

Im Falle eines Brandes kann bei der in Fig. 3 gezeigten Schaltung durch Beaufschlagung der Photovoltaikmodule mit einem zu diesem durch die erste Diode fließenden Strom entgegengesetzten Strom leicht voneinander getrennt werden. Dieser aufgegebene, entgegengesetzte Strom bewirkt, dass die zweite Diode nun durchströmt wird, folglich die elektrische Widerstandsheizung 146 sich aufheizt und die darin erzeugte Temperatur auf die Schmelzsicherung durch direkte Wärmeleitung überträgt. Die erste Diode 143 sperrt in diesem Fall die Schmelzsicherung, so dass der zur Auslösung der Schmelzsicherung aufgegebene, entgegengesetzte Strom alleinig über den zweiten Parallelleitungsstrang 145 fließt.

## Patentansprüche

1. Photovoltaikanlage, umfassend,
- ein erstes Photovoltaikmodul (1),
- ein zweites Photovoltaikmodul (2),
- eine elektrische Verbindung (5) zwischen dem ersten und dem zweiten Photovoltaikmodul, und
- eine elektrische Schaltvorrichtung (11) zur Trennung der elektrischen Verbindung,
**dadurch gekennzeichnet, dass** die elektrische Schaltvorrichtung (11) eine Schmelzsicherung (42; 142) und eine Heizvorrichtung (46; 146) umfasst, welche ausgebildet und so zu der Schmelzsicherung angeordnet ist, dass bei Beheizung der Heizvorrichtung die Schmelzsicherung auslöst und die elektrische Verbindung (5) trennt.

2. Photovoltaikanlage nach Anspruch 1, wobei die Photovoltaikmodule über einen Anschluss (1a; 3b) mittels einem ersten und einem zweiten Leiter mit einem Wechselrichter verbindbar sind,
**dadurch gekennzeichnet, dass** die elektrische Schaltvorrichtung fortgebildet ist, indem die Heizvorrichtung über den gleichen Anschluss (1a; 3b) mit dem ersten und zweiten Leiter verbindbar sind zur Beaufschlagung des Heizvorrichtung mit einem Heizstrom.

3. Photovoltaikanlage nach Anspruch 1 oder 2,
**dadurch gekennzeichnet, dass** die elektrische Schaltvorrichtung fortgebildet ist, indem sie
- einen ersten Anschlusspol (12; 112) zum Anschluss des ersten Photovoltaikmoduls und
- einen zweiten Anschlusspol (22; 122) zum Anschluss des zweiten Photovoltaikmoduls aufweist und
dass der erste und der zweite Anschlusspol
- durch eine erste elektrische Verbindung (41; 141), welche die Schmelzsicherung beinhaltet, und
- eine zweite, parallel zur ersten elektrischen Verbindung zwischen den ersten und zweiten Anschlusspol verlaufenden elektrischen Verbindung (45; 145) miteinander verbunden sind,
wobei die Heizvorrichtung in der zweiten elektrischen Verbindung angeordnet ist.

4. Photovoltaikanlage nach Anspruch 3,
**dadurch gekennzeichnet, dass** die elektrische Schaltvorrichtung fortgebildet ist, indem in der zweiten elektrischen Verbindung ein Kondensator (47) in Reihe zu der Heizvorrichtung angeordnet ist.

5. Photovoltaikanlage nach Anspruch 3 oder 4,
**gekennzeichnet durch** eine Wechselstromquelle, die mit der Heizvorrichtung zur Beaufschlagung der Heizvorrichtung mit einem Wechselstrom elektrisch verbunden ist.

6. Photovoltaikanlage nach Anspruch 3,
**dadurch gekennzeichnet, dass** die elektrische Schaltvorrichtung fortgebildet ist, indem
- in der ersten elektrischen Verbindung vorzugsweise eine erste Diode (143) in einer ersten Sperrichtung von dem ersten zum zweiten Anschlusspol in Reihe zu der Schmelzsicherung angeordnet ist, und
- in der zweiten elektrischen Verbindung eine zweite Diode (147) in einer zweiten, der ersten entgegengesetzten Sperrichtung von dem zweiten zum ersten Anschlusspol in Reihe zu der Heizvorrichtung angeordnet ist.

7. Photovoltalkanlage nach Anspruch 6,
**gekennzeichnet durch** eine Gleichstromquelle, die mit der Heizvorrichtung zur Beaufschlagung der Heizvorrichtung mit einem Gleichstrom in Durchlassrichtung der zweiten Diode verbunden ist.

8. Photovoltaikanlage nach einem der vorhergehenden Ansprüche,
mit einem Wechselrichter in einem Wechselrichtergehäuse, der beabstandet von dem ersten und zweiten Photovoltaikmodul angeordnet und mit diesen elektrisch über eine Leitung mit einem ersten und einem zweiten Leiter verbunden ist,
**gekennzeichnet durch** eine Heizstromquelle, die mit der Heizvorrichtung mittels des ersten und zweiten Leiters elektrisch verbunden ist und die vorzugsweise in dem Wechselrichtergehäuse oder benachbart zu diesem angeordnet ist.

9. Photovoltaikanlage nach einem der vorhergehenden Ansprüche,
**dadurch gekennzeichnet, dass** die Schmelzsicherung (42; 142) zur irreversiblen Trennung der elektrischen Verbindung zwischen dem ersten und dem zweiten Photovoltaikmodul ausgebildet ist.

10. Photovoltaikanlage nach einem der vorhergehenden Ansprüche,
**dadurch gekennzeichnet, dass** die elektrische Schaltvorrichtung fortgebildet ist, indem die elektrische Verbindung einen ersten, mit dem ersten Photovoltaikmodul verbundenen ersten Anschlusspol über die Schmelzsicherung mit einem zweiten, mit dem zweiten Photovoltaikmodul verbundenen zweiten Anschlusspol verbindet und ausgebildet ist, um bei Überschreitung einer vorbestimmten Temperatur den ersten von dem zweiten Anschlusspol elektrisch voneinander zu trennen und den ersten oder den zweiten Anschlusspol mit einem Massepunkt zu verbinden.

11. Photovoltaikanlage nach einem der vorhergehenden Ansprüche, mit drei oder mehr miteinander elektrisch verbundenen Photovoltaikmodulen, **dadurch gekennzeichnet, dass** jeweils eine elektrische Verbindung zwischen zwei Photovoltaikmodulen ausgebildet ist und jede elektrische Verbindung eine elektrische Schaltvorrichtung mit den Merkmalen der elektrischen Schaltvorrichtung nach einem der vorhergehenden Ansprüche aufweist, wobei jede elektrische Schaltvorrichtung fortgebildet ist, indem die elektrische Verbindung einen ersten, mit dem ersten Photovoltaikmodul verbundenen ersten Anschlusspol über die Schmelzsicherung mit einem zweiten, mit dem zweiten Photovoltaikmodul verbundenen zweiten Anschlusspol verbindet und ausgebildet ist, um bei Überschreitung einer vorbestimmten Temperatur den ersten von dem zweiten Anschlusspol elektrisch voneinander zu trennen und den ersten oder den zweiten Anschlusspol mit einem Massepunkt zu verbinden.

12. Elektrische Schaltung zur Verbindung eines ersten und eines zweiten Photovoltaikmoduls, umfassend:
- eine elektrische Verbindung (41) zwischen dem ersten (12; 112) und dem zweiten (22; 122) Photovoltaikmodul, und
- eine elektrische Schaltvorrichtung (10; 11) zur Trennung der elektrischen Verbindung,
**dadurch gekennzeichnet, dass** die elektrische Schaltvorrichtung eine Schmelzsicherung (42; 142) und eine Heizvorrichtung (46; 146) umfasst, welche ausgebildet und so zu der Schmelzsicherung angeordnet ist, dass bei Beheizung der Heizvorrichtung die Schmelzsicherung auslöst und die elektrische Verbindung trennt.

13. Elektrische Schaltung nach Anspruch 12,
**dadurch gekennzeichnet, dass** die elektrische Schaltvorrichtung mit den Merkmalen der elektrischen Schaltvorrichtung nach einem der vorhergehenden Ansprüche 1-10 fortgebildet ist.

14. Verfahren zur Sicherung einer Photovoltaikanlage mit mehreren, elektrisch miteinander verbunden Photovoltaikmodulen im Falle eines Brandes, mit den Schritten:
- Beaufschlagen einer im Bereich der Photovoltaikmodule angeordneten Heizvorrichtung mit einem Heizstrom,
- Beheizen einer im Bereich der Heizvorrichtung angeordneten Schmelzsicherung mittels der Heizvorrichtung,
- Durchtrennen der Schmelzsicherung mittels der Temperatureinwirkung aus der Heizvorrichtung und hierdurch Trennen der elektrischen Verbindung zwischen dem ersten und zweiten Photovoltaikmodul.

15. Verfahren nach Anspruch 14, bei dem der in den Photovoltaikmodulen erzeugte Strom über einen ersten und einen zweiten elektrischen Leiter zu einem beabstandet angeordneten Wechselrichter geleitet wird,
**dadurch gekennzeichnet, dass** ein Heizstrom über den ersten und zweiten Leiter zu der Heizvorrichtung geleitet wird, und
- der Heizstrom als Wechselstrom zu einer parallel zur Schmelzsicherung geschalteten Heizeinheit geleitet wird, welche die in Reihe zu einem Kondensator geschaltete Heizvorrichtung umfasst, oder
- der Heizstrom als Gleichstrom zu einer parallel zur Schmelzsicherung geschalteten Heizeinheit geleitet wird, welche die in Reihe zu einer Diode geschaltete Heizvorrichtung umfasst.
